# EUROPEAN PATENT APPLICATION

(11) **EP 4 686 331 A1**
(43) Date of publication of application: **28.01.2026**
(21) Application number: 25191128.5
(22) Date of filing: 22.07.2025
(51) Int. Cl.: H05K 7/20

(54) **LIQUID MANIFOLD ASSEMBLY FOR ELECTRONICS CABINET**

(30) Priority: 22.07.2024 US 202463674142 P
(71) Applicant: Hoffman Enclosures Inc., Anoka, MN 55303 (US)
(72) Inventor: DeMars, Allen, Elk River (US)
(74) Representative: Barker Brettell LLP

(57) **Abstract**

A manifold assembly (100) for a server rack includes a manifold tube (102) defining a first face (104) and a second face (106), a fluid port (110) extending outwardly from the first face, and a mounting assembly (130) to secure the manifold tube to the server rack. The mounting assembly includes a mounting block (150) secured to the second face of the manifold tube and a mounting channel (132) having a pair of side walls (138) extending from a base (134). The side walls of the mounting channel are attached to corresponding lateral surfaces of the mounting block to secure the manifold tube to the server rack.

## Description

### BACKGROUND

In some cooling system applications, a manifold may deliver flows of cooling fluid to and from electronics supported on a rack within a cabinet or stack. For example, some liquid cooling systems can include manifolds that allow pumped fluid to individually cool multiple server trays that are stacked vertically within a server rack or other arrangement. The manifolds can be mounted to the server rack and support the server trays.

### SUMMARY

According to one aspect of the present disclosure, a manifold assembly for a server rack can include a manifold tube defining a first face and a second face. A fluid port can extend outwardly from the first face. A mounting assembly can secure the manifold tube to the server rack. The mounting assembly can include a mounting block secured to the second face of the manifold tube, and a mounting channel having a pair of side walls extending from a base. The side walls of the mounting channel can be attached to corresponding lateral surfaces of the mounting block to secure the manifold tube to the server rack.

In some examples, the mounting block can be at least partially received into an internal space of the mounting channel, the internal space being defined by the side walls and the base of the mounting channel.

In some examples, the mounting channel can be offset from the second face of the manifold tube.

In some examples, the offset of the mounting channel from the second face of the manifold tube can be based on a distance between the second face of the mounting tube and the base of the mounting channel.

In some examples, the manifold tube can define a rectangular cross-sectional area.

In some examples, the mounting channel can include an alignment member that extends from the base of the mounting channel.

In some examples, the fluid port can be a quick-connect coupling configured to engage with a corresponding fluid port of electrical equipment supported by the server rack.

In some examples, the mounting block can be attached to the manifold tube via welded connections.

In some examples, the mounting channel can include a substantially U-shaped cross-section.

According to another aspect of the present disclosure, a method of mounting a manifold assembly for a server rack can include providing a manifold tube having a first surface, a second surface, and a fluid port extending from the first surface, the fluid port to provide liquid coolant to an electrical component. The method can include securing a mounting block to the second surface of the manifold tube, arranging the mounting block within a mounting channel separate from the manifold tube and the mounting block, and securing the manifold tube to the server rack by attaching the mounting block within the mounting channel.

In some examples, the mounting block can be secured to the second surface of the manifold tube by welding the mounting block to the second surface of the manifold tube.

In some examples, the mounting channel can be secured to the mounting block by welding one or more side walls of the mounting channel to a corresponding lateral surface of the mounting block.

In some examples, a base of the mounting channel can be offset from the second surface of the manifold tube.

In some examples, offsetting the mounting channel from the second surface can include determining an offset distance based on one or more of: a first distance between the first surface of the manifold tube and the base of the mounting channel; and a second distance between a distal end of the fluid port and the base of the mounting channel.

In some examples, the mounting channel can include an alignment member that extends from a base of the mounting channel.

According to yet another aspect of the present disclosure, a manifold assembly for a rack of electronic equipment can include a manifold tube extending along an elongate portion of the manifold assembly. A channel can extend along the elongate portion of the manifold assembly and can include a side wall and a base, the channel to support the manifold tube relative to the rack. A mounting block can be positioned at least partially within a space defined by the side wall and the base, the mounting block connecting the manifold tube and the channel.

In some examples, the mounting block can be connected to each of the manifold tube and the channel via one or more weld connections.

In some examples, the side wall of the channel can be spaced from a surface of the manifold tube.

In some examples, the mounting block can be secured to the channel along the side wall of the channel.

In some examples, the channel can include a guide pin for extending through a corresponding aperture of the rack.

This Summary and the Abstract are provided to introduce a selection of concepts in a simplified form that are further described below in the Detailed Description. This Summary is not intended to identify key features or essential features of the claimed subject matter, nor are they intended to be used as an aid in determining the scope of the claimed subject matter.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the assembly or any component described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the disclosed technology and, together with the description, serve to explain the principles of examples of the disclosed technology:
FIG. 1 is an axonometric view of a manifold assembly according to an example of the disclosed technology;
FIG. 2 is a partial axonometric view of the manifold assembly of FIG. 1, showing details of a welding block of the manifold assembly;
FIG. 3 is a side elevation view of the manifold assembly of FIG. 1;
FIG. 4 is a partial top view of the manifold assembly of FIG. 1; and
FIG. 5 is a flowchart of an example manifold assembly process according to an example of the disclosed technology.

### DETAILED DESCRIPTION

Before any examples of the disclosed technology are explained in detail, it is to be understood that the disclosed technology is not limited in its application to the details of construction and the arrangement of components set forth in the following description or illustrated in the following drawings. The disclosed technology is capable of other examples and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use examples of the present disclosure. Various modifications to the illustrated examples will be readily apparent to those skilled in the art, and the generic principles herein can be applied to other examples and applications without departing from examples of the present disclosure. Thus, examples of the present disclosure are not intended to be limited to examples shown but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the present disclosure. Skilled artisans will recognize the examples provided herein have many useful alternatives and fall within the scope of examples of the present disclosure.

Some of the discussion below describes interfaces between structures of a liquid manifold and an enclosure (e.g., a server rack) that can be used to help provide liquid cooling to server racks. The context and particulars of this discussion are presented as examples only. For example, examples of the disclosed technology can be used in other contexts, such as for cooling computing equipment other than servers, or various other electronics, configured in various ways, including with other shapes and arrangements of elements.

When electronic equipment is cooled using liquid coolant, it can be useful to provide blind mate connections and quick connect (e.g., quick disconnect) fittings at interfaces between electrical equipment and other components along a cooling loop (e.g., a liquid manifold). For example, a server or other electronics assembly can be configured to be readily (e.g., partly automatically) aligned for connection to a flow system for liquid cooling of the server or other electronics as the assembly is moved into position for operation. This may allow operators to ensure secure attachment of fluid couplings (e.g., fluid ports of the manifold and the servers) without manual engagement of the couplings or particular attention to alignment of the various components during installation.

Typically, a manifold assembly can be mounted to a server rack via ancillary mounting features or brackets that are fabricated separately from a fabrication of the manifold assembly. However, individual tolerances of the ancillary mounting features can contribute to tolerance stack up between fluid ports of the manifold assembly and corresponding fluid ports of electrical equipment (e.g., a server tray). Thus, when electrical equipment is inserted into a server rack, a tolerance at an interface between the electrical equipment and the manifold assembly may be tight or the electrical equipment and the manifold assembly may be offset, which can lead to misalignment between interfaces of the fluid ports.

In some cases, deformation and tolerance stack-up of a manifold tube can result in misalignment between fluid ports of the manifold and corresponding fluid ports of electrical equipment to be fluidly connected to the liquid manifold. In some cases, a manifold tube or parts of electrical equipment can be deformed, such that orientation or position of fluid ports of a liquid manifold relative to fluid ports of electrical equipment changes. In some cases, misalignment of fluid ports and system deformation can result in fluid leakage, which can damage electrical equipment and other equipment in a data center, or weak or no fluid connections.

In various manufacturing and operational scenarios, manifold tubes can be deformed due to various factors. In some cases, deformation can be introduced in a manifold tube through manufacturing processes that generate significant heat (e.g., friction, drilling, etc.). In some cases, forces exerted on a liquid manifold tube over time can produce deformation, including variations in heat load of the manifold tube, forces introduced on the manifold tube as a result of mounting of the manifold tube to a rack, a weight of the manifold tube, a pressure at fluid ports of a manifold, etc. For example, manifolds that are manufactured from formed (e.g., bent, stamped, or laser cut) sheet metal can be susceptible to deformation produced by forces on the manifold (e.g., a force produced by attachment points between the manifold and a server rack, deformation from liquid pressure at ports along the manifold, etc.). In some cases, manufacturing ports in a thick-walled tube (e.g., tubes with a wall thickness of .25 inches or greater) can include methods that create distortion (e.g., warping) or shrinkage of the manifold tube. Further, in some cases, a manifold tube can have varying wall thickness along a length, or at different sides of the manifold tube (e.g., due to variations in tolerances). Accordingly, for example, it may be difficult in conventional systems to ensure appropriate alignment of blind-mate connectors and, correspondingly, fluid connection, between opposing sides of fluid couplings. As noted above, this may be problematic due to the effects of exposing electronics to certain liquids (e.g., liquid coolant, water).

Considerations beyond dimensional variation can also complicate the task of achieving secure and predictable connections at fluid couplings for liquid cooling. For example, pressure of fluid flow at fluid couplings can tend to urge the couplings to separate, with corresponding forces on associated manifolds and electronics racks. Additionally, many quick-connect couplings incorporate spring-loaded components. The springs can exert significant forces on manifolds and electronics racks, particularly for non-locking connections in which spring forces may not be absorbed by locking devices during system operation. In this regard, for example, some manifolds may be subject to lateral loading of 800 pounds or more during operation. Such loading can also create (or exacerbate) problems with misalignment of components, including for manifolds that may be secured to larger support structures at a small number of attachment points (e.g., less than four attachment points).

In some cases, a manifold or manifold assembly can be generally susceptible to deflection or deformation along a manifold tube. In some conventional manifolds or manifold assemblies, thick-walled manifold tubes are utilized to prevent deformation. However, this can increase a weight of the manifold assembly, which can increase a difficulty of installation of the manifold. Further, thick-walled manifolds can be susceptible to deformation in a manufacturing or machining of the manifold. For example, a thickness of the wall can make some precision manufacturing techniques (e.g., CNC) impractical, and can require friction-producing methods to cut or drill portions of the thick-walled manifold. Deformations can be produced in a manifold due to heat and friction produced in machining ports, as generally described above.

It can therefore be advantageous to provide improved systems and methods for achieving alignment between fluid ports of a manifold tube and corresponding fluid ports of electrical equipment (e.g., despite deformation and tolerance stack-up of the manifold tube due to manufacturing processes).

Examples of manifold assemblies according to this disclosure can address these and other issues by helping to ensure appropriately aligned engagement between fluid ports on cooling manifolds and on electronics assemblies (e.g., to facilitate blind-mate connections between ports of a manifold assembly and electrical equipment in a rack). In particular, examples of the present disclosure can provide systems and methods for ensuring appropriate alignment for a manifold assembly, for example, by compensating for dimensional variations of a manifold tube.

According to some examples, a manifold assembly can include a manifold tube and a mounting assembly. The mounting assembly may be fixed (e.g., welded) to the manifold tube and adjustably mounted to a server rack. The mounting assembly can provide fixed datum features (e.g., datum planes, protrusions, edges, etc.) that define known dimensions for the manifold assembly relative to a rack, to which the manifold assembly is mounted.

In particular, the manifold assembly can include a mounting feature that provides geometric variations between subcomponents of the manifold assembly. Accordingly, the manifold assembly can accommodate overall critical tolerances (e.g., between a mounting surface of a manifold assembly and a fluid port of a manifold tube). Mounting assemblies can be configured to ensure a proper depth alignment of the manifold assembly. By maintaining particular distances between datum planes of a manifold assembly, the mounting assembly can help to ensure that ports of the manifold assembly are appropriately aligned along at least one dimension (e.g., in a depth direction) when the manifold assembly is mounted to the rack.

In some examples, a manifold assembly can include a mounting channel (e.g., a bracket, a brace, a support element, a support structure, etc.) for attaching the manifold assembly to an enclosure or a rack. The manifold assembly can include a mounting block that is positioned within the mounting channel. The mounting block can also be welded to a manifold tube and the mounting channel at a desired position. In some examples, a position of a mounting block can be adjusted laterally or front-to-back relative to a manifold tube or a mounting channel. Accordingly, the mounting block can compensate for tolerance stack-up of a manifold assembly incurred during manufacturing or fabrication of a manifold assembly, or lateral loading of a manifold assembly during operation of liquid cooling. Thus, individual components of manifold assemblies can be manufactured at a reduced cost or improved manufacturability (e.g., production capacity, production speed, or scalability).

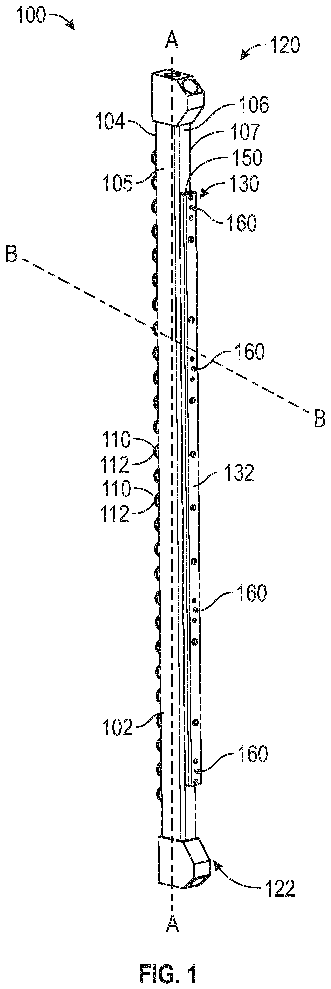

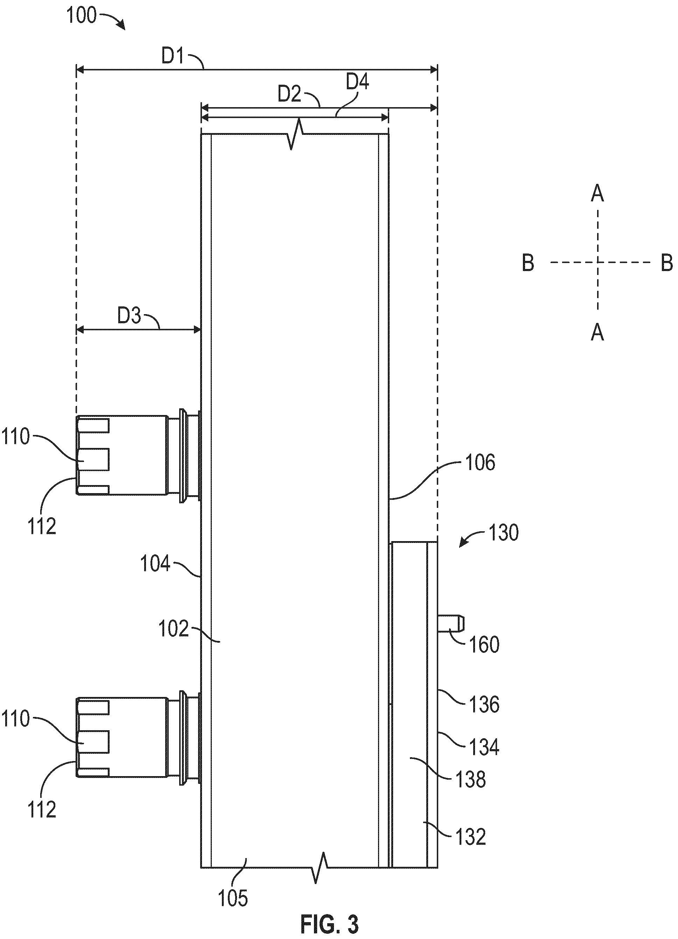

A manifold assembly can include a manifold tube with a plurality of ports that can be positioned to align with corresponding ports of electrical equipment when the manifold assembly is mounted to a rack of electrical equipment. In this regard, FIGS. 1-4 illustrate an example manifold assembly 100 according to examples of the present disclosure. Referring to FIG. 1, the manifold assembly 100 includes a manifold tube 102, a plurality of ports 110 (e.g., quick-connect couplings, a plurality of fluid ports) and a mounting assembly 130. The mounting assembly 130 can be provided to secure the manifold assembly 100 to a server rack or an enclosure frame of the server rack. The manifold assembly 100 can be coupled to the server rack to provide a path for coolant flow via the ports 110 and to transfer heat away from electronics of the server rack. The ports 110 can extend from the manifold tube 102 in a depth direction parallel to axis B (e.g., in a direction toward electrical equipment within the rack). The ports 110 can define an axis that is parallel to axis B. The ports 110 can include a distal end 112 and be defined by a length D3 (shown in FIG. 3) as measured in a direction parallel to axis B.

A manifold tube can be sized and configured to distribute a flow of fluid through a rack, and to facilitate a mounting of a manifold assembly to a rack. As shown in FIG. 1, the manifold tube 102 (and the manifold assembly 100) can be elongated along an elongate portion of the manifold assembly 100 in a first direction, parallel to axis A (e.g., a longitudinal axis). Axis A can be a perpendicular axis, with the manifold assembly 100 being installed with the elongate direction oriented vertically when the manifold assembly 100 is mounted to a rack of electrical equipment. The manifold tube 102 can define a rectangular cross-sectional area along a fluid flow path (e.g., the manifold tube 102 can be a square tube). For example, the manifold tube 102 can define a front wall 104 (e.g., a first face), a rear wall 106 (e.g., a second face), and tube lateral walls 105, 107. The walls 104, 105, 106, 107 can extend in a direction parallel to axis A and can each define corresponding outer surfaces that are substantially planar. As illustrated, the ports 110 can extend outwardly from the front wall 104, and the front wall 104 can be proximate electrical equipment when the manifold assembly is mounted to a rack. The rear wall 106 can be opposite the front wall 104 in the direction parallel to axis B (e.g., a depth direction parallel to a direction in which the ports 110 extend). The tube lateral walls 105, 107 can each extend between the front wall 104 and the rear wall 106. In other examples, a manifold tube can define other cross-sectional shapes. For example, a manifold tube can be cylindrical (e.g., with a circular cross-section) triangular, hexagonal, star-shaped, etc.

Referring to FIG. 1, the manifold assembly 100 can be secured in a vertical orientation within a rack and can provide for liquid coolant flow (e.g., can provide or receive a fluid coolant) through electrical equipment (e.g., servers, batteries, network switches, storage disks and drives, etc.) housed at different heights within the rack when connected to a fluid coolant loop. As shown, a top portion 120 is positioned at a first distal end of the manifold assembly 100 (e.g., a distal end in the direction parallel to axis A), and a bottom portion 122 is positioned at a second distal end of the manifold assembly 100 opposite the first distal end. The manifold assembly 100 can include a port at the top portion 120 or the bottom portion 122 to fluidly connect the manifold assembly to a coolant loop (e.g., to either receive a fluid coolant at a "supply" or to expel a fluid coolant at a "return"). The plurality of ports 110 can distribute the received fluids to electrical equipment (e.g., a server tray) or receive fluids from the electrical equipment when aligned and connected with corresponding ports of the electrical equipment.

With continued reference to FIG. 1, the plurality of ports 110 can be configured to matingly engage corresponding fluid ports of electrical equipment. In some examples, ports of a manifold assembly can be received into corresponding ports of electrical equipment (e.g., fluid ports of a manifold assembly can have a male configuration). In other examples, ports of a manifold assembly can receive corresponding fluid ports of electrical equipment (e.g., fluid ports of the manifold assembly can have a female configuration). The plurality of ports 110 can be quick-connect couplings. When the manifold assembly 100 is mounted in a rack, the ports 110 can be positioned to be aligned and blind-mated with ports of electrical equipment to be cooled. The manifold assembly 100 can facilitate a toolless fluid connection between the ports 110 and corresponding ports of electrical equipment (e.g., without fasteners, weldment, adhesives, etc.) when the manifold assembly 100 is mounted to a rack. For example, the electrical equipment can comprise a server chassis and can be installed into a rack by sliding the server chassis onto a corresponding shelf of the server rack. When the server chassis is received at a shelf, one or more ports of the electrical equipment may click into place with a corresponding port of the plurality of ports 110. Thus, blind mate connections can reduce labor cost or reduce errors in establishing fluid connections (e.g., thus preventing fluid leakage at the ports 110).

Referring to FIG. 1, the mounting assembly 130 includes structures and elements that help to secure the manifold assembly 100 to a server rack or an enclosure frame. In some configurations, the mounting assembly 130 can include a mounting channel 132 and a plurality of mounting blocks 150. In the illustrated example, the mounting channel 132 can be configured as a bracket that extends along an elongate portion of the manifold assembly 100 in the direction parallel to axis A. The mounting channel 132 can be configured to support a weight of the manifold tube 102. The mounting blocks 150 can be attached to the mounting channel 132 at a predetermined location, for example, to position the mounting channel 132 at a desired location. The mounting blocks 150 can be distributed along the mounting assembly 130 in the direction parallel to axis A to support the manifold assembly 100 at one or more locations.

With continued reference to FIG. 1, the mounting blocks 150 can be secured directly to rear wall 106 of the manifold tube 102, and the mounting channel 132 can be secured to the mounting blocks 150. For example, the mounting blocks 150 can be secured (e.g., welded) to the tube rear wall 106 via various joining techniques including welding, fastening, or adhering. The mounting blocks 150 can be welded (e.g., via butt-lap welds) to the manifold tube 102 and the mounting channel 132, establishing a welded connection (e.g., a laser welded connection). In some examples, the mounting channel 132 can be welded to the manifold tube 102 via welds (e.g., butt-lap welds) on a plurality mounting blocks distributed along the tube rear wall 106. Welding the mounting channel 132 to the manifold tube 102 at multiple points can balance a weld distortion to minimize deformation from welding (e.g., due to warping or heating). The welded connections can advantageously reduce a friction or deformation of the components. In some cases, other connection types can be used to secure a manifold tube, mounting blocks, and a channel respectively, including welded connections, fasteners, interlocking geometries, adhesives, etc.

In some implementations, the mounting channel 132 can be positioned relative to the manifold tube 102 to compensate for dimensional variations of the manifold tube 102 or a deformation produced in the manifold tube 102. In particular, as discussed above, the dimensional variations or deformation of the manifold tube 102 can be introduced during a machining process (e.g., a deformation produced through friction drilling of holes for ports 110). In some examples, the mounting blocks 150 can be secured to the manifold tube 102 (i.e., to the rear wall 106) after the manifold tube has been machined (e.g., after the manifold tube 102 is cut to length, the holes for the ports 110 are drilled, the ports 110 are mounted within the holes, etc.). The mounting blocks 150 can be positioned on the manifold tube 102 to enforce a lateral position of the ports 110 when the manifold assembly 100 is mounted to a rack. Further, as described below, the mounting channel 132 can be fixed (e.g., welded) to the mounting blocks 150, and a position (e.g., a vertical position, and a depth position) of the mounting channel 132 can be selected to enforce a vertical position (e.g., a position along axis A) and a depth position (e.g., a position along axis B) of the ports 110 when the manifold assembly is mounted to the rack. Thus, a positioning of mounting blocks and channels of a mounting assembly can compensate for dimensional variance and tolerance stack-up of a manifold tube and can ensure alignment of ports of a manifold assembly with corresponding ports of electrical equipment within a cabinet.

In some examples, a manifold tube of a manifold assembly (e.g., the manifold tube 102) can be constructed of steel. In some examples, a manifold tube can define a square cross-sectional profile with side lengths of about 1.5 inches. In some examples, the length of sides of the square cross-sectional profile can be about 1.25 inches, about 1.75 inches, about 2 inches, about 2.5 inches, or about 2.6 inches. In some examples, the manifold tube 102 can include moderately thick walls, so that a wall thickness of the tube is less than about 0.25 inches. In some examples, a wall thickness of the walls of the manifold tube can be about 0.188 in, about 0.12 in, about 0.109 in, about 0.095 in, about 0.083 in, about 0.072 in, about 0.065 in, about 0.049 in, or about 0.035 in. In some case, a wall thickness of the manifold tube can be between about 0.049 in and about 0.75 in. Unless otherwise specified or limited, the terms "about" and "approximately," as used herein with respect to a reference value, refer to variations from the reference value of ± 20% or less (e.g., ± 15, ± 10%, ± 5%, etc.), inclusive of the endpoints of the range. In some cases, a width of a manifold tube can correspond to a side of liquid ports required for the manifold tube, and forces exerted at liquid ports (e.g., fluid pressure and spring forces). In some cases, a larger diameter of liquid ports can require relatively thicker walls for a manifold tube, to allow for retention of the liquid port relative to the tube. In some cases, a number of liquid ports along a manifold tube can correlate to a thickness of the manifold tube, For example, a manifold tubes with a greater number of liquid ports can require greater wall thickness (e.g., due to increased fluid pressure and spring pressure from quick-disconnect fittings) than manifolds tubes having a lesser number of liquid ports.

As shown in FIG. 1, the illustrated manifold assembly 100 includes twenty-seven ports 110, although a manifold assembly can include more ports or fewer ports in some configurations. In some cases, a number of the ports 110 can correspond to a length of a manifold (e.g., ports can be spaced along the manifold at uniform distances). In some cases, a number of the ports 110 can correspond to a number of servers in a rack in which the manifold assembly 100 is installed. For example, a server rack can include a predefined number of vertical shelves (e.g., slots) for housing electrical equipment having standard heights (e.g., 1 rack unit (U) or about 44 mm). A spacing of ports along a liquid manifold can correspond to a vertical spacing between shelves in the rack (e.g., ports of a manifold can be spaced apart from adjacent ports by about 1U or about 2U). This arrangement can allow the plurality of ports 110 to be at a fixed position relative to corresponding shelves of a server rack when the manifold assembly 100 is mounted to the server rack. When electrical equipment (e.g., a server, a switch, a storage device, etc.) is mounted to the rack within a shelf (e.g., in an installed position), a fluid port of the electrical equipment can be positioned on the electrical equipment to matingly engage one of the fluid ports 110 of the manifold assembly 100 corresponding to the shelf.

In some cases, fluid ports of a manifold can be dimensioned (e.g., spaced vertically) to accommodate particular rack configurations (e.g., non-standard or bespoke installations, installation heights defined by industry standards, national or international regulations, etc.). For example, in some examples, a manifold assembly can include 42 ports (e.g., one port for each 1U slot in a rack having 42U). In some cases, shelves of a rack can be configured to receive components having a height of 2U, and a manifold assembly can have 21 ports to correspond to each 2U slot within a rack. In some cases, a rack can include a mix of electronic components having different heights (e.g., a storage rack having 1U storage nodes and 2U or 4U disk shelves) and manifold assemblies can include a number of ports corresponding to a total number of electronic components in shelves of the rack, the ports being spaced to correspond to a spacing of the electronic components in the rack.

Further, a diameter of the fluid ports (e.g., a diameter of the quick connect fittings comprising the fluid ports) can be adapted for particular applications to achieve desired flow rates and pressure characteristics of cooling systems in which the liquid manifold is installed.

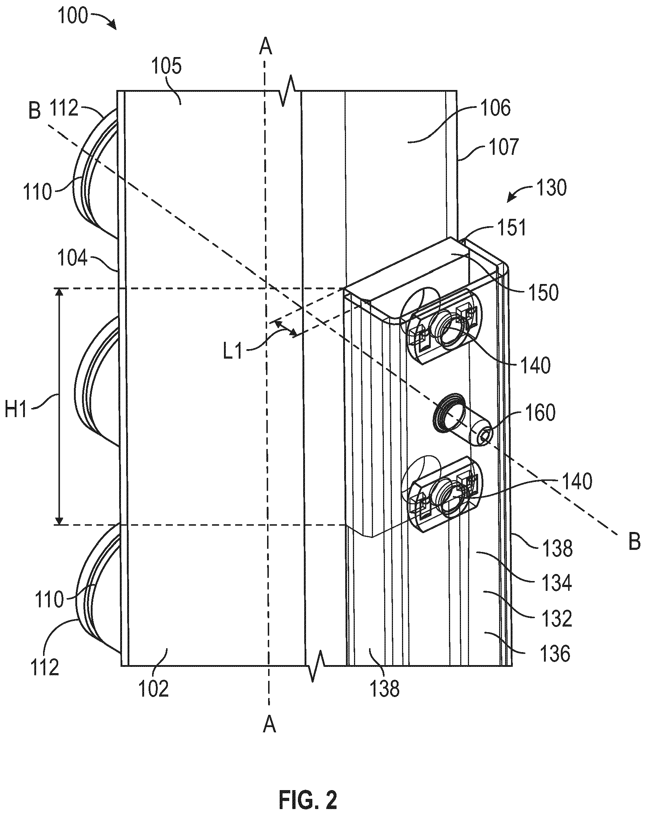

Turning to FIG. 2, the mounting channel 132 is shown transparently to illustrate details of the mounting assembly 130 including the mounting channel 132 and the mounting block 150. As shown, the mounting block 150 can be at least partially received within the mounting channel 132, which can be defined by a channel rear wall 134 (e.g., a base) and channel lateral walls 138 (e.g., a pair of side walls) extending from the channel rear wall 134. The channel rear wall 134 defines a rear plane 136, and the channel lateral walls 138 extend substantially perpendicularly to the channel rear wall 134 on opposite sides of the channel rear wall 134. The rear plane 136 can include lines that extend in the direction parallel to axis A. The channel lateral walls 138 are substantially parallel to each other, although the channel lateral walls 138 can be angled differently (e.g., outwardly, inwardly, or at an oblique angle). When the mounting assembly 130 is attached to the manifold tube 102, the channel lateral walls 138 extend in a substantially parallel direction to the tube lateral walls 105, 107. As such, at least a portion of the mounting block 150 is received within a space defined by the channel rear wall 134 and the channel lateral walls 138. A depth of the internal space (e.g., a length of the channel lateral walls 138 in the direction parallel to axis B) can be greater than a dimension of the mounting block 150 in the direction parallel to axis B.

In the illustrated example, the mounting channel 132 is an elongated channel defining a U-shaped cross-section, although C-shaped cross-section is possible in some examples. When the mounting channel 132 is fixed to the manifold assembly 100, an elongate dimension of the mounting channel 132 can extend in the direction parallel to axis A (e.g., the mounting channel 132 can be vertically oriented).

As further illustrated in FIG. 2, the mounting channel 132 includes features and structures that help to provide precise alignment and attachment points of the manifold assembly 100 to a server rack. In the illustrated example, the mounting channel 132 can include a plurality of guide pins 160 (e.g., one or more guide pins or multiple guide pins, or a plurality of alignment members, a plurality of protrusions). The guide pin 160 can extend outwardly from the channel rear wall 134 in a direction away from the electrical equipment within a rack (e.g., in a direction opposite a direction in which the ports 110 extend from the manifold tube). In the illustrated example, the guide pin 160 defines a circular cross-sectional profile. However, in other examples, a guide pin can be triangular, rectangular, star-shaped, or can define any cross-sectional profile that can facilitate an engagement with a corresponding feature of a rack.

The guide pin 160 can provide a locating feature for the manifold assembly 100. For example, the guide pin 160 can extend through a corresponding aperture or a recessed feature (not shown) on a server rack to mount the manifold assembly 100 to the server rack. The manifold assembly 100 can be assembled (e.g., the mounting blocks 150 can be welded to the manifold tube 102 and the mounting channel 132 can be welded to the mounting blocks 150) to ensure that the guide pin 160 is at a predefined position relative to geometries of the manifold tube 102 (e.g., the ports 110, the front wall 104, etc.). Thus, inserting the guide pin 160 into the server rack can ensure an appropriate alignment between the manifold assembly 100 and the server rack, or at least partially constraint a displacement of the manifold assembly 100 relative to the server rack in at least one direction (e.g., one or both of a vertical direction and a lateral direction).

Turning briefly back to FIG. 1, the plurality of guide pins 160 are spaced along the mounting channel 132 in the direction parallel to axis A. In the illustrated example, the mounting channel 132 includes 4 guide pins 160. In some case, a number of guide pins can be less than four or greater than four. In some cases, a number and positioning of guide pins can be determined by adherence to industry standards, government regulations, standards specific to one or more data centers, etc.

Turning to FIG. 2, the plurality of mounting blocks 150 can be sized and positioned to ensure a lateral alignment of the ports 110 of the manifold assembly 100, and can provide surfaces for mounting the mounting channel 132 to the mounting blocks 150. In the illustrated example, the mounting block 150 can be rectangular. The mounting block 150 can define a height H1 in the direction parallel to axis A and a thickness L1 in the direction parallel to axis B. The mounting block 150 can include lateral surfaces 151 on opposing lateral sides of the mounting block 150. The lateral surface 151 can be configured as engagement surfaces for the mounting channel 132, and the mounting channel 132 can be attached to the corresponding lateral surfaces 151 of the mounting block 150 to secure the manifold tube 102 to the server rack. For example, a surface of the channel lateral walls 138 can be welded (e.g., laser welded) to a corresponding one of the lateral surfaces 151 to secure the mounting channel 132 to the mounting block 150 (e.g., to the manifold assembly 100). The mounting block 150 can be welded to the channel lateral walls 138 via various welding techniques (e.g., laser welding, arc welding, gas welding, flux welding, friction welding, plasma arc welding, etc.), although other types of joining methods (e.g., fastening, adhering, etc.) are possible in other examples.

With continued reference to FIG. 2, a surface area of engagement between the channel 132 and the plurality of mounting blocks 150 can correspond to a load capacity of the manifold assembly 100. For example, in some cases, manifolds assemblies can be provided for high-flow applications of liquid coolant and can be subject to greater loads as a result (e.g., due to the pressure of the liquid coolant). In some cases, a number of mounting blocks (e.g., and thus a total engagement surface area between the mounting blocks and the channel) can be determined based on a rated load for the manifold assembly, with manifold assemblies for higher-load applications including a greater number of mounting blocks. A greater number of mounting blocks or a greater dimension of a mounting block (e.g., the height H1 or the thickness L1) can provide a greater surface area and correspondingly, greater support for withstanding weight of the manifold assembly 100.

Further, the illustrated manifold assembly 100 includes four mounting blocks (one mounting block 150 shown in FIGS. 1, 2, and 4), spaced along the direction parallel to axis A (e.g., vertically distributed). In other examples, a manifold assembly can include 2 mounting blocks, or more than 3 mounting blocks. In some cases, the mounting block 150 can be formed with a weldable material (e.g., copper, aluminum, steel, magnesium, etc.). In some cases, the mounting block 150 can include weight-reducing features (e.g., a blind hole, a through hole, etc.) to decrease an overall material weight of the manifold assembly 100 (e.g., to reduce strain on the manifold tube 102 or the mounting channel 132).

Referring to FIG. 2, the channel rear wall 134 can define a mounting interface with a server rack. The manifold assembly 100 can be mounted to a server rack along the rear plane 136. The mounting channel 132 includes one or more apertures 140 that are configured to receive fasteners (e.g., screws or bolts) for securing the manifold assembly 100 to the server rack. In particular, the apertures 140 can be provided at different vertical positions on the channel rear wall 134 (e.g., to provide variability in mounting positions). For example, as shown in FIG. 2, the guide pin 160 (e.g., each of the guide pins 160) can be centrally located (e.g., in the direction parallel to axis A) between apertures 140. In some cases, the apertures 140 can be configured as threaded apertures, and fasteners can extend through both of a portion (e.g., a rail) of a rack and the apertures 140.

Further, engagement of the guide pin 160 with a server rack, combined with the fasteners secured through the apertures 140, can determine a height and lateral position of the manifold assembly 100 relative to the rack. Correspondingly, a height of the plurality of ports 110 (e.g., a vertical alignment thereof) along the manifold assembly 100 can be determined. In some cases, a location of an aperture on a server rack (e.g., to receive the guide pin 160) can be defined particular rack configurations (e.g., as determined by industry standards or government codes).

Referring to FIG.3, one or more datums can be defined for the manifold assembly 100 to ensure a lateral or front-to-back alignment of the plurality of ports 110 relative to a server rack or electrical equipment. In some examples, the mounting channel 132 can be mounted to the manifold tube 102 or the mounting block 150 to achieve predetermined dimensions, such as a specific distance between datums or between a datum and other features, a specific distance relative to a fixed location, or a location of a surface relative to a known dimension. In some examples, to achieve quick-connect fitting, it may be desirable to position the manifold assembly 100 at a particular point to align the plurality of ports 110 to corresponding ports of electrical equipment, which may be fixed in position. In some cases, various standards-such as an industry standard, a government regulation, a client-specific standard, a standard based on a rack configuration, etc.-can require a fixed distance between a rear surface of a manifold assembly (e.g., the channel rear wall 134) and a front surface (e.g., the front wall 104), or between a rear surface of the manifold assembly (e.g., the channel rear wall 134) and a distal end of a port (e.g., the distal end 112). Thus, maintaining fixed dimensions between features of a manifold assembly relative to a datum of the manifold assembly (e.g., a surface engaging a surface of a rack) can ensure an appropriate positioning of the ports 110 of the manifold assembly 100.

Referring to FIG. 3, the mounting channel 132 can provide a datum that ensures a depth alignment of the manifold assembly 100 relative to a server rack or electrical equipment. For example, the mounting channel 132 can be welded to the mounting block 150 or the manifold tube 102 to achieve a desired depth or distance, as measured in the direction parallel to axis B, between the rear plane 136 and features of the manifold tube 102. In particular, the rear plane 136 can be configured as a datum plane, and the mounting channel 132 can be welded to the mounting block 150 to achieve a set distance D1 (e.g., a first distance) between rear plane 136 and the distal end 112. The distance D1 is measured in the direction parallel to axis B. Further, the mounting channel 132 can be welded to the mounting block 150 to achieve a set distance D2 (e.g., a second distance) between the front wall 104 and the rear plane 136. The distance D2 is measured in the direction parallel to axis B. Accordingly, welding the mounting block 150 to one or more portions of the manifold assembly 100 or the mounting assembly 130 can provide flexibility in fine-tuning the positional or orientational accuracy of the ports 110 relative to a server rack. In the illustrated configuration, while the distance D1 and the distance D2 are shown to specify distances between datums, the channel 132 can be positioned on the manifold assembly 100 to achieve preset distances between the rear plane 136 of the mounting channel 132 and other features of the manifold assembly 100.

With continued reference to FIG. 3, the guide pins 160 can be a datum (or can be defined relative to a datum) that constraints a lateral or vertical position of the manifold assembly 100. For example, the mounting assembly 130 can be positioned along the manifold tube 102 to ensure a position of the ports 110 relative to a position of the guide pins 160. The guide pin 160 can extend from the rear plane 136 of the mounting channel 132 to matingly engage with a corresponding recessed feature on a server rack. Thus, a location of the guide pin 160 can provide a connection point that constraints the manifold assembly 100 in one or more of a height direction (e.g., the direction parallel to axis A) or a lateral direction (e.g., a direction transverse to both of axis A and axis B). Further, positioning of the mounting assembly 130 can compensate for a tolerance stack-up of the manifold tube 102 during fabrication process.

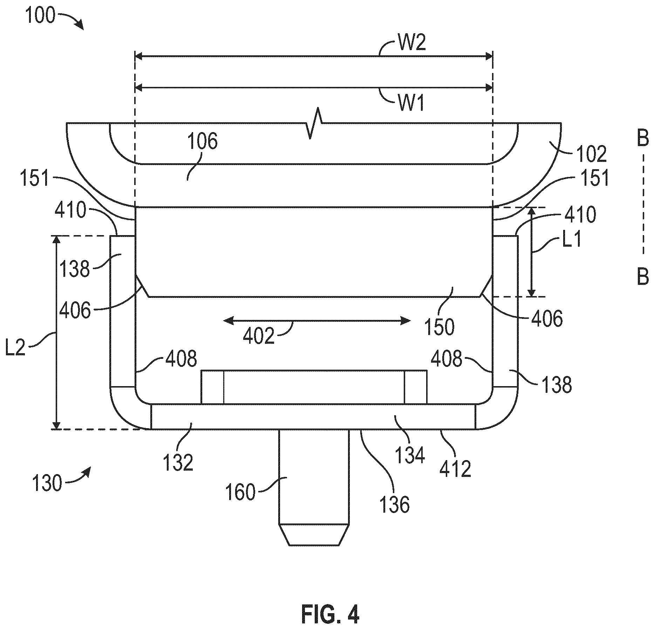

FIG. 4 illustrates a top view of the mounting block 150 positioned between the tube rear wall 106 (e.g., an outer surface of the tube rear wall 106) and the mounting channel 132. As discussed above, the mounting block 150 can be secured (e.g., welded) to the tube rear wall 106 after a fabrication process (e.g., friction drilling, cutting, attachment of quick-disconnect ports, inlet and outlet port, etc.) of the manifold tube 102 has been complete. Put differently, the mounting block 150 can be positioned on a manifold tube 102 after any deformation or dimensional variation caused through a fabrication process has already occurred, and the mounting block 150 can thus be positioned to compensate for this dimensional variation. For example, after a fabrication process, a position of ports 110 of the manifold assembly can be laterally offset from a center of the front wall 104, or orientated at an oblique angle, or otherwise positioned at a lateral offset. In some cases, the mounting block 150 can be welded to a particular point along the tube rear wall 106 in a lateral direction or to the mounting channel 132 to overcome an offset positioning of the ports 110. In some examples, the mounting block 150 can be welded to a particular point along the tube rear wall 106 to achieve a desired lateral distance between the tube lateral walls 105, 107 (shown in FIGS. 1 and 2) and the channel lateral walls 138. Thus, the configuration of the mounting block 150 can enhance positional adjustability of the manifold assembly 100 relative to a server rack or electrical equipment to compensate for deformation and dimensional variation of a manifold tube. Accordingly, when the manifold assembly 100 is mounted to the server rack, the mounting block 150 can help to ensure that the ports 110 are positioned correctly in a lateral direction 402, to establish a connection between the ports 110 and the corresponding ports of electrical equipment.

With continued reference to FIG. 4, the mounting block 150 can be defined by a width W1 (e.g., in the lateral direction) and the length L1 (e.g., in a direction parallel to axis B). Further, the mounting block 150 can define beveled edges 406 at corners of the mounting block 150. Advantageously, the beveled edges 406 can aid in aligning the mounting block 150 within the mounting channel 132 or fitting the mounting block 150 between the channel lateral walls 138. The mounting channel 132 can define an inner width W2 that extends between inner surfaces 408 of the channel lateral walls 138 and a length L2 that extends between a distal end 410 of either one of the channel lateral walls 138 and an outer surface 412 of the channel rear wall 134. The length L2 is measured in the direction parallel to axis B.

Referring to FIG. 4, the width W1 and the width W2 are substantially similar, although the width W1 can be smaller than the width W2 to permit the mounting block 150 to be received between the inner surfaces 408. Welds or adhesives can be applied at interfaces between sides of the mounting block 150 and the channel lateral walls 138 for secure bonding between the mounting block 150 and the mounting channel 132. One or more of the mounting block 150 or the mounting channel 132 can be fixed to the manifold tube 102 (e.g., along the tube rear wall 106) and be moved in the lateral direction 402. With the guide pin 160 supporting the mounting assembly 130 at a predefined position, adjusting a lateral position of the mounting assembly 130 can help to position the manifold tube 102 (e.g., thus the plurality of ports 110) relative to a server rack or electrical equipment.

With continued reference to FIG. 4, the position of the mounting channel 132 relative to the mounting block 150 can be adjusted to achieve a desired dimension of the distance D1 or the distance D2 (as shown in and discussed relative to FIG. 3). In particular, the length L1 is shorter than the length L2, as can advantageously allow for flexibility in positioning the mounting channel 132 relative to the mounting block 150 in the depth direction parallel to axis B. For example, the channel lateral walls 138 can be attached to the mounting block 150 along the lateral surfaces 151 of the mounting block 150. Accordingly, the mounting channel 132 can be positioned along the depth direction relative to the mounting block 150 to achieve a desired distance between the rear plane 136 and a feature of the manifold assembly 100, including the distance D1 and the distance D2 (as shown in FIG. 3). Thus, when the manifold assembly 100 is mounted to a server rack, the flexible configuration of the mounting channel 132 can provide a precise control over the position of the ports 110 relative to the server rack.

Referring to FIGS. 3 and 4, the adjustable positioning of the mounting channel 132 relative to the manifold tube 102 can allow for compensation of manufacturing tolerances in parts of the manifold assembly 100, to ensure proper alignment and connection of the ports 110 and the ports of electronic equipment. For example, a total depth D4 of the manifold tube 102 can vary by a tolerance from a standard depth (e.g., a basic dimension, a predefined depth, a specified depth, etc.). The depth D4 is measured in a direction parallel to axis B. The depth D4 can be wider or thinner than the standard depth of the manifold tube 102. When the depth D4 is shorter than the standard depth, the mounting channel 132 can be welded to the mounting block 150 at an offset from the manifold tube 102 (e.g., from the rear wall 106) to maintain the distance D1 or the distance D2. Conversely, when the manifold tube 102 is thicker in a depth dimension than the standard depth, the mounting channel 132 can be positioned relatively nearer (e.g., at a smaller offset) to the manifold tube 102 to maintain the distance D1 or the distance D2. Accordingly, incorporating the mounting block 150 can help to compensate for the variability in manufacturing and maintain the distance D1 or the distance D2.

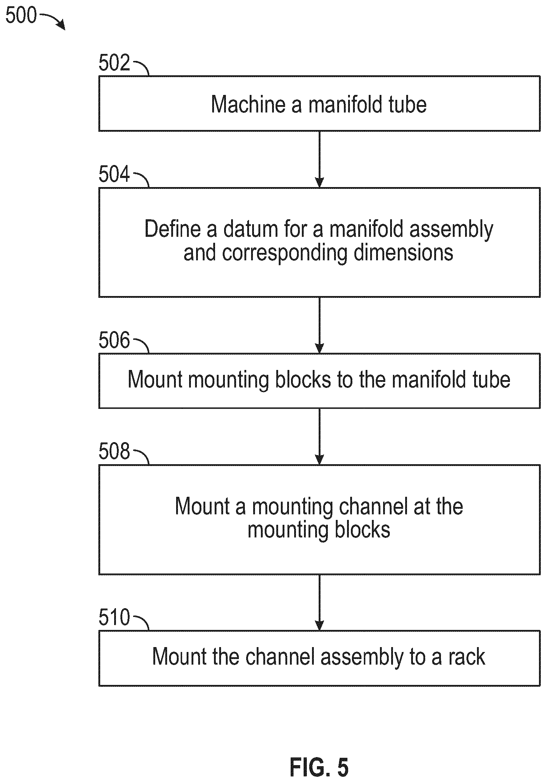

FIG. 5 illustrates an example method 500 of assembling a manifold assembly according to aspects of the present disclosure. At block 502, a manifold tube (e.g., the manifold tube 102 shown in FIGS. 1-4) can be machined. Machining the manifold tube can include forming the manifold tube from a sheet metal, cutting the manifold tube to length, producing port apertures in the manifold tube (e.g., through friction drilling, laser cutting, etc.), mounting ports at the port apertures, mounting caps on distal ends of the manifold tube, etc. As discussed above, machining or fabricating the manifold tube can result in dimensional variation (e.g., due to tolerance stack-up) of the manifold tube from a specified configuration for the manifold tube. Thus, it can be challenging to consistently define a datum on the manifold tube itself, since enforcing dimensionality between portions of the manifold tube can be challenging.

At block 504, one or more datums can be defined for a manifold assembly including the manifold tube machined at block 502. A datum can be defined based on pre-selected standards. For example, as discussed above, a particular company, industry standard, government regulation, etc. can require a fixed total depth for the manifold assembly (e.g., either of the distances D1, D2 shown in FIG. 3), or a fixed vertical and lateral position of ports of a manifold assembly relative to other features (e.g., the guide pins 160 of FIGS. 1-4). A rear surface (e.g., the channel rear wall 134 of FIGS. 2-4) can include a datum from which dimensions (e.g., a depth) can be determined. A position of guide pins (e.g., the guide pins 160) can further define a datum, or starting point for measurements, and a relative positioning of elements of a mounting assembly (e.g., the mounting blocks 150 and the mounting channel 132) can be set to provide desired dimensions of the manifold assembly relative to the defined datums.

At block 506, the mounting blocks (e.g., the mounting blocks 150 shown in FIGS. 1-4) can be mounted to the manifold tube. A position of the mounting blocks relative to the mounting tube can be determined based on a known geometry of the manifold tube. For example, the mounting blocks can be welded to the manifold tube at a predetermined lateral position that can ensure that ports of the manifold assembly are properly located in a lateral direction. If the ports are offset from center in a first lateral direction, for example, the mounting block can be mounted (e.g., welded) to a rear wall of the manifold tube at an offset from center in a second lateral opposite the first lateral direction to ensure a desired lateral alignment of the ports when the manifold assembly is mounted within a rack.

At block 508, a mounting channel can be mounted to the mounting blocks (e.g., the mounting blocks mounted at block 506). A relative positioning of the mounting channel relative to the mounting blocks (e.g., relative to the manifold tube) can be selected to achieve a predetermined dimension of one or more features of the manifold tube relative to one or more features of the channel. For example, the mounting channel can be positioned at a depth offset relative to the manifold tube to achieve a predetermined distance between a rear surface of the mounting channel and a front surface of the manifold tube (e.g., the distance D2 shown in FIG. 3). In some examples, the mounting channel can be positioned at a predetermined depth position along lateral surfaces of the mounting block. Further, the mounting channel can be aligned vertically (e.g., along axis A of FIGS. 1-3) relative to the mounting blocks to achieve a predetermined vertical offset between the pins and ports of the manifold tube.

In some implementations, offsetting the mounting channel from the rear wall of the manifold tube can include determining an offset distance based on one or more predetermined dimensions (e.g., the distance D1 or the distance D2 shown in FIG. 3). For example, the offset distance may be determined based on a first distance between the front wall of the manifold tube and the rear channel wall of the mounting channel. The first distance may correspond to a desired overall depth of the manifold assembly when mounted to a server rack. Additionally or alternatively, the offset distance may be determined based on a second distance between a distal end of the fluid port and the rear wall of the manifold tube. The second distance may be crucial for ensuring proper alignment and engagement of the fluid ports with corresponding ports on the server equipment when the manifold assembly is installed.

At block 510, the mounting assembly can be mounted to a rack. When the mounting assembly is mounted to the rack, one or more datums of the mounting assembly can be positioned at a fixed position relative to the rack. For example, the guide pins of the manifold assembly can be received into corresponding apertures of the rack, and when so received, a position of ports of the manifold assembly can be fixed at a known position within the rack (e.g., due to a known dimension of the ports relative to the guide pins). Further, when a datum surface (e.g., a rear surface of a channel) is in contact with a corresponding feature or surface of the rack, a depth of the ports can be known to adhere to a given standard, due at least in part to the positioning of the mounting blocks at block 506 and the mounting channel at block 508.As noted above, features of a manifold assembly can provide one or more planes (e.g., a datum plane) for defining a spatial relationship between a manifold tube and a mounting channel. For example, a mounting block can be provided between a manifold tube and a mounting channel to space apart from one another. Further, a mounting channel can be secured (e.g., welded) at a surface defining an interface (e.g., a datum plane), and can thus define spatial relationships between other portions of a manifold tube and a mounting assembly.

In some implementations, devices or systems disclosed herein can be utilized or installed using methods embodying aspects of the disclosed technology. Correspondingly, description herein of particular features or capabilities of a device or system is generally intended to inherently include disclosure of a method of using such features for intended purposes and of implementing such capabilities. Similarly, express discussion of any method of using a particular device or system, unless otherwise indicated or limited, is intended to inherently include disclosure, as examples of the disclosed technology, of the utilized features and implemented capabilities of such device or system. For example, aspects of the disclosed technology can include the manufacture or installation of the various manifold assemblies discussed above, as well as operation of a cooling system that includes such assemblies.

In the methods described herein, the steps can be carried out in any order without departing from the principles of the disclosure, except when a temporal or operational sequence is explicitly recited. Recitation in a claim to the effect that first a step is performed, and then several other steps are subsequently performed, shall be taken to mean that the first step is performed before any of the other steps, but the other steps can be performed in any suitable sequence, unless a sequence is further recited within the other steps. For example, claim elements that recite "Step A, Step B, Step C, Step D, and Step E" shall be construed to mean step A is carried out first, step E is carried out last, and steps B, C, and D can be carried out in any sequence between steps A and E, and that the sequence still falls within the literal scope of the claimed process. A given step or sub-set of steps can also be repeated. Furthermore, specified steps can be carried out concurrently unless explicit claim language recites that they be carried out separately. For example, a claimed step of doing X and a claimed step of doing Y can be conducted simultaneously within a single operation, and the resulting process will fall within the literal scope of the claimed process.

The previous description of the disclosed examples is provided to enable any person skilled in the art to make or use the disclosed technology. Various modifications to these examples will be readily apparent to those skilled in the art, and the generic principles defined herein may be applied to other examples without departing from the spirit or scope of the disclosed technology. Thus, the disclosed technology is not intended to be limited to the examples shown herein but is to be accorded the widest scope consistent with the principles and novel features disclosed herein.

### FURTHER EXAMPLES

Example 1. A manifold assembly for a server rack, the manifold assembly comprising: a manifold tube defining a first face and a second face; a fluid port extending outwardly from the first face; and a mounting assembly to secure the manifold tube to the server rack, the mounting assembly including: a mounting block secured to the second face of the manifold tube; and a mounting channel having a pair of side walls extending from a base, and the side walls of the mounting channel being attached to corresponding lateral surfaces of the mounting block to secure the manifold tube to the server rack.

Example 2. The manifold assembly of Example 1, wherein the mounting block is at least partially received into an internal space of the mounting channel, the internal space being defined by the side walls and the base of the mounting channel.

Example 3. The manifold assembly of Example 1 or Example 2, wherein the mounting channel is offset from the second face of the manifold tube.

Example 4. The manifold assembly of Example 3, wherein the offset of the mounting channel from the second face of the manifold tube is based on a distance between the second face of the mounting tube and the base of the mounting channel.

Example 5. The manifold assembly of any one of Examples 1 to 4, wherein the manifold tube defines a rectangular cross-sectional area.

Example 6. The manifold assembly of any one of Examples 1 to 5, wherein the mounting channel includes an alignment member that extends from the base of the mounting channel.

Example 7. The manifold assembly of any one of Examples 1 to 6, wherein the fluid port is a quick-connect coupling configured to engage with a corresponding fluid port of electrical equipment supported by the server rack.

Example 8. The manifold assembly of any one of Examples 1 to 7, wherein the mounting block is attached to the manifold tube via welded connections.

Example 9. The manifold assembly of any one of Examples 1 to 8, wherein the mounting channel includes a substantially U-shaped cross-section.

Example 10. A method of mounting a manifold assembly for a server rack, the method comprising: providing a manifold tube having a first surface, a second surface, and a fluid port extending from the first surface, the fluid port to provide liquid coolant to an electrical component; securing a mounting block to the second surface of the manifold tube; arranging the mounting block within a mounting channel separate from the manifold tube and the mounting block; and securing the manifold tube to the server rack by attaching the mounting block within the mounting channel.

Example 11. The method of Example 10, wherein the mounting block is secured to the second surface of the manifold tube by welding the mounting block to the second surface of the manifold tube.

Example 12. The method of Example 10 or Example 11, wherein the mounting channel is secured to the mounting block by welding one or more side walls of the mounting channel to a corresponding lateral surface of the mounting block.

Example 13. The method of any one of Examples 10 to 12, wherein a base of the mounting channel is offset from the second surface of the manifold tube.

Example 14. The method of Example 13, wherein offsetting the mounting channel from the second surface includes determining an offset distance based on one or more of: a first distance between the first surface of the manifold tube and the base of the mounting channel; and a second distance between a distal end of the fluid port and the base of the mounting channel.

Example 15. The method of any one of Examples 10 to 14, wherein the mounting channel includes an alignment member that extends from a base of the mounting channel.

Example 16. A manifold assembly for a rack of electronic equipment, the manifold assembly comprising: a manifold tube extending along an elongate portion of the manifold assembly; a channel extending along the elongate portion of the manifold assembly and including a side wall and a base, the channel to support the manifold tube relative to the rack; and a mounting block positioned at least partially within a space defined by the side wall and the base, the mounting block connecting the manifold tube and the channel.

Example 17. The manifold assembly of Example 16, wherein the mounting block is connected to each of the manifold tube and the channel via one or more weld connections.

Example 18. The manifold assembly of Example 16 or Example 17, wherein the side wall of the channel is spaced from a surface of the manifold tube.

Example 19. The manifold assembly of any one of Examples 16 to 18, wherein the mounting block is secured to the channel along the side wall of the channel.

Example 20. The manifold assembly of any one of Examples 16 to 19, wherein the channel includes a guide pin for extending through a corresponding aperture of the rack.

Unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of' (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Unless otherwise specified or limited, the terms "about" and "approximately," as used herein with respect to a reference value, refer to variations from the reference value of ± 20% or less (e.g., ± 15, ± 10%, ± 5%, etc.), inclusive of the endpoints of the range. Similarly, as used herein with respect to a reference value, the term "substantially equal" (and the like) refers to variations from the reference value of ± 5% or less (e.g., ± 2%, ± 1%, ± 0.5%) inclusive. Where specified in particular, "substantially" can also indicate a significant variation relative to a reference value. For example, the term "substantially less" than a reference value (and the like) indicates a value that is reduced from the reference value by 30% or more (e.g., 35%, 40%, 50%, 65%, 80%), and the term "substantially more" than a reference value (and the like) indicates a value that is increased from the reference value by 30% or more (e.g., 35%, 40%, 50%, 65%, 80%).

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

Also as used herein, unless otherwise defined or limited, the term "substantially identical" indicates components or features that are manufactured to the same specifications (e.g., as may specify materials, nominal dimensions, permitted tolerances, etc.), using the same manufacturing techniques. For example, multiple parts stamped from the same material, to the same tolerances, using the same mold may be considered to be substantially identical, even though the precise dimensions of each of the parts may vary from the others.

As used herein, unless otherwise limited or defined, "substantially perpendicular" indicates a direction that is within ± 12 degrees of perpendicular a reference direction (e.g., within ± 6 degrees or ± 3 degrees), inclusive.

Also as used herein, unless otherwise limited, a "fluid port" means any feature that provides a transition into or out of a particular system along a fluid particular flow path. Thus, for example, a fluid port can include simple openings in structures that are configured for fluid flow, or more complex mechanisms such as fluid couplings (e.g., a quick-connect coupling). A fluid port can include one or more features or one or more components (e.g., may be an assembly of multiple parts) that can provide the transition in or out of a particular system. For example, a fluid port can include a fitting (e.g., a quick-connect coupling) and corresponding features (e.g., an inlet aperture) on a system (e.g., a pipe or manifold) in communication with the fitting.

Also as used herein, the term "datum" refers to a reference geometry that establishes a known dimension between components. For example, a datum plane can be a plane with a known (e.g., a predefined) depth relative to another plane or component. A datum mounting feature can have a fixed offset from ports of a manifold assembly, for example, such that the ports are positioned at a known position in a three-dimensional space relative to a rack when the datum mounting feature is received into a corresponding feature of a rack. In some cases, a datum can define a fixed starting point relative to which dimensions are defined for a component.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Features of the assembly and/or any components described may be incorporated into/used in corresponding methods and vice versa.

## Claims

1. A manifold assembly for a server rack, the manifold assembly comprising:
a manifold tube defining a first face and a second face;
a fluid port extending outwardly from the first face; and
a mounting assembly to secure the manifold tube to the server rack, the mounting assembly including:
a mounting block secured to the second face of the manifold tube; and
a mounting channel having a pair of side walls extending from a base, and the side walls of the mounting channel being attached to corresponding lateral surfaces of the mounting block to secure the manifold tube to the server rack.

2. The manifold assembly of claim 1, wherein the mounting block is at least partially received into an internal space of the mounting channel, the internal space being defined by the side walls and the base of the mounting channel.

3. The manifold assembly of any of claims 1 or 2, wherein the mounting channel is offset from the second face of the manifold tube.

4. The manifold assembly of claim 3, wherein the offset of the mounting channel from the second face of the manifold tube is based on a distance between the second face of the mounting tube and the base of the mounting channel.

5. The manifold assembly of any of the preceding claims, wherein the manifold tube defines a rectangular cross-sectional area.

6. The manifold assembly of any of the preceding claims, wherein the mounting channel includes an alignment member that extends from the base of the mounting channel.

7. The manifold assembly of any of the preceding claims, wherein the fluid port is a quick-connect coupling configured to engage with a corresponding fluid port of electrical equipment supported by the server rack.

8. The manifold assembly of any of the preceding claims, wherein the mounting block is attached to the manifold tube via welded connections.

9. The manifold assembly of any of the preceding claims, wherein the mounting channel includes a substantially U-shaped cross-section.

10. A method of mounting a manifold assembly for a server rack, the method comprising:
providing a manifold tube having a first surface, a second surface, and a fluid port extending from the first surface, the fluid port to provide liquid coolant to an electrical component;
securing a mounting block to the second surface of the manifold tube;
arranging the mounting block within a mounting channel separate from the manifold tube and the mounting block; and
securing the manifold tube to the server rack by attaching the mounting block within the mounting channel.

11. The method of claim 10, wherein the mounting block is secured to the second surface of the manifold tube by welding the mounting block to the second surface of the manifold tube.

12. The method of any of claims 10 or 11, wherein the mounting channel is secured to the mounting block by welding one or more side walls of the mounting channel to a corresponding lateral surface of the mounting block.

13. The method of any of the claims 10-12, wherein a base of the mounting channel is offset from the second surface of the manifold tube.

14. The method of claim 13, wherein offsetting the mounting channel from the second surface includes determining an offset distance based on one or more of:
a first distance between the first surface of the manifold tube and the base of the mounting channel; and
a second distance between a distal end of the fluid port and the base of the mounting channel.

15. The method of any of claims 10-14, wherein the mounting channel includes an alignment member that extends from a base of the mounting channel.
